# EUROPÄISCHE PATENTSCHRIFT

(11) **EP 1 825 498 B1**
(45) Veröffentlichungstag und Bekanntmachung des Hinweises auf die Patenterteilung: **17.02.2010**
(21) Anmeldenummer: 05822302.5
(22) Anmeldetag: 19.12.2005
(51) Int. Cl.: H01J 61/35, C03C 17/34

(54) **INNENBESCHICHTUNG VON LAMPENGEFÄSSEN, WIE ENTLADUNGSGEFÄSSEN VON GASENTLADUNGSLAMPEN**
INSIDE COATING OF LAMP BULBS, SUCH AS DISCHARGE TUBES OF GAS DISCHARGE LAMPS
REVETEMENT INTERIEUR D'AMPOULES, TELLES QUE DES TUBES A DECHARGE OU DES LAMPES A DECHARGE

(30) Priorität: 17.12.2004 DE 102004061632
(43) Veröffentlichungstag der Anmeldung: 29.08.2007
(73) Patentinhaber: Auer Lighting GmbH, 37581 Bad Gandersheim (DE)
(72) Erfinder: KÜPPER, Thomas, 37581 Bad Gandersheim (DE); HAMEL, Margareta, 37136 Ebergötzen (DE); MÖLLE, Christoph, 55131 Mainz (DE); EHRLICHMANN, Dietmar, 12169 Berlin (DE); KRONFOTH, Rainer, 12623 Berlin (DE); GÜNTHER, Klaus, 16837 Neu Lutterow (DE)
(74) Vertreter: Herden, Andreas F.
(86) Internationale Anmeldenummer: PCT/EP2005/013643
(87) Internationale Veröffentlichungsnummer: WO 2006/063854

(56) Entgegenhaltungen:
- EP-A- 0 501 562
- EP-A- 1 084 996
- DE-A1- 4 208 376
- US-A- 4 345 180
- US-A- 4 574 218
- US-A1- 2001 055 930
- US-A1- 2003 102 805

## Beschreibung

Die Erfindung betrifft ein Lampengefäß, beispielsweise ein Entladungsgefäß aus einem Quarzglas für Entladungslampen, mit einer Diffusionsbarriereinnenschicht.

Als Gefäßmaterial für die Brenner von Hochdruck-Entladungslampen steht bekannterweise Quarzglas oder Aluminiumoxid zur Verfügung.
Hierbei muss vor allem der Schutzfunktion des Entladungsgefäßmaterials für einen gleichbleibenden Gasentladungsprozess und damit der Langzeitstabilität der Lampe Rechnung getragen werden. Das Entladungsgefäß mit dem eingeschlossenen Entladungsraum, den Elektroden und der Füllung wird auch als Brenner bezeichnet.

Wesentliche Vorgänge, welche die Lebensdauer von solchen Brennern begrenzen, sind die Diffusion von Füllungsbestandteilen aus dem Entladungsraum in oder auch durch die Gefäßwandung. Die Zusammensetzung der Füllung bestimmt sowohl Lichtausbeute als auch Farbort der Entladung, welche sich bei Veränderung der Zusammensetzung der Füllung infolge Diffusion einzelner Bestandteile entsprechend verschiebt.

Diese Farbverschiebungen sind aus mehreren Gründen nachteilig: Beispielsweise Lampen im Automobilbereich müssen in der gesamten Lebensdauer gesetzlichen Anforderungen an den Farbort erfüllen. Eine möglichst geringe Farbdrift ist deshalb für eine hohe Lampenlebensdauer von großer Bedeutung. Ferner sollten beim Auswechseln einer einzelnen Scheinwerferlampe keine erkennbaren Farbunterschiede zwischen rechtem und linkem Scheinwerfer aufgrund unterschiedlicher Brenndauern entstehen.

Ein Beispiel hierfür ist die Diffusion des Natriums als Füllungsbestandteil in das Quarzglas eines Entladungsgefäßes während der Lebensdauer solcher Lampen. Die Beweglichkeit von Natriumatomen ist derart, dass Quarzglas, d.h. glasartiges amorphes Siliziumdioxid (SiO₂) relativ porös für das Natrium ist. Die Stärke dieses Diffusionsprozesses hängt unter anderem stark von der Löslichkeit und Beweglichkeit von Natrium im Entladungsgefäßglas ab. Die Diffusionsgeschwindigkeit der Natriumionen durch glasartiges Siliziumdioxid folgt einer Exponentialfunktion der Temperatur.
Durch den Verlust von Natrium im Brennerraum reduziert sich der relative Strahlungsanteil von Natrium an der Gesamtstrahlung. Da Natrium vorwiegend im Gelbbereich emittiert verschiebt sich die Farbtemperatur der Lampe zu höheren Farbtemperaturen (ins Blaue).

Ein weiterer Prozess während der Lampenlebensdauer ist bei Füllungen mit Scandium als Bestandteil die Bildung von Scandiumsilikat. Über Geschwindigkeit und Ausmaß dieser Reaktionen ist bisher wenig bekannt. Es lässt sich aber qualitativ gut nachweisen und führt zu einem Verlust an für die Entladung verfügbarem Scandium und damit ebenfalls zu Farbverschiebungen.

Ein Beispiel für eine entsprechende Entladungslampe gibt die US 2003/0189408 A1. Hier werden als Gasfüllungsbestandteile neben Xenon (Xe) für quecksilberfreie HID-Lampen Natrium (Na), Scandium (Sc) und Zink (Zn) genannt, welche jeweils als Natriumiodid, Scandiumiodid und Zinkiodid einer Xenongasfüllung beigemischt werden.

Weiterhin muss festgestellt werden, dass ebenso die Entglasung eines Quarzglasentladungsgefäßes ein lebensdauerbegrenzender Faktor ist. Die Füllung der Lampe wirkt dabei entglasungsfördernd, da Na, Sc und im Falle von quecksilberfreien Lampen auch Zn enthalten sind.
Eine Passivierung der Quarzoberfläche gegenüber dem Angriff der Füllung ist daher geeignet, Entglasungsprozesse zu verlangsamen.

Ferner ist die Passivierung nützlich um Kreisprozesse in Hochdrucklampen zu stabilisieren, da Plasma-Wand-Wechselwirkungen zur unerwünschten Freisetzung oder Aufnahme von Wasserstoff und Sauerstoff in bzw. aus dem Entladungsvolumen führen können.

Die Auswahl von polykristallinem transluzentem Aluminiumoxid (Al₂O₃) als Brennermaterial ist im Vergleich zu Quarzglas recht kostenintensiv, erfordert aufgrund anderer Materialeigenschaften zusätzlich konstruktive Anpassungen der Brennergeometrie und führt aufgrund der fehlenden Transparenz zu einem Verlust an Leuchtdichte.

Um die Vorteile von Quarzglas als Substratmaterial für Entladungsgefäße nutzen zu können, wurden verschiedene Anstrengungen unternommen, die Lebensdauer von Entladungslampen mit Quarzglasbrennern entsprechend jeweils vorliegender Anforderungen zu steigern.
So schlägt die DE 42 08 376 Schutzschichten u.a. aus Al₂O₃ oder SiO₂ auf dem Quarzglas gegen Korrosion und Erosion durch das ständige Bombardement durch Elektronen und Ionen vor, welche durch die Mikroentladungen im Entladungsraum verursacht werden und die Entladungsgefäßwände angreifen.

Die hier aufgetragene Schutzschicht soll durch das Elektronenbombardement verursachte Bindungsbrüche ("Erosion") im Glas unterbinden.

Die US 4,345,180 offenbart einen Lampenkolben aus boriertem Quarzglas, welcher innen mit einer borierten Quarzglasschicht mit geringerer Bor-Konzentration ausgekleidet ist, das Bor soll die Kristallisation des Quarzglases vermeiden. Der geringere Bor-Gehalt der glasige Schutzschicht soll die Wasseraufnahme des Glases verringern.

In der US 2001/055930 A1 wird die Innenbeschichtun von Glasröhre mit siO₂ als Stand der Technik beschrieben.

Aus der DE 41 15 437 ist eine Schutzschicht aus Al₂O₃ oder SiO₂ auf dem Glas einer Kathodenstrahlröhre bekannt, welches eine Braunfärbung des Glases unterbinden soll, welche infolge einer direkten chemischen Reaktion zwischen der Glasoberfläche und einem aufgetragenen Mehrschichtinterferenzfilter aufgrund Elektronenbombardements auftritt.

In diesen beiden Fällen wirkt die Schutzschicht als Pufferschicht gegen ein Bombardement von Teilchen, aber sie gibt keine Lösung für das Problem der Diffusion von Gasfüllungsbestandteilen aus dem Entladungsraum. Hierfür werden Barrierebeschichtungen aus Al₂O₃, aus Quarzglas oder Al₂O₃ als Substratmaterial für Entladungsgefäße vorgeschlagen.

So beschreibt die DE 102 16 092 eine Barrierebeschichtung aus Aluminiumoxid auf der dem Entladungsraum zugewandten Oberfläche des Entladungsgefäßes aus Quarzglas. Diese Barrierebeschichtung soll eine Barriere gegen Diffusion von Na in das Quarzglas bilden und dasselbe vor Halogenangriffen schützen. Zur Beschichtung mittels eines Plasma-unterstützten CVD-Verfahrens, vorzugsweise eines PICVD-Verfahrens, wird als Precursor-Gas Aluminiumchlorid (AlCl₃) in einer Atmosphäre aus O₂ vorgeschlagen (CVD = Chemical Vapor Deposition, PICVD = Plasma Impulsed Chemical Vapor Deposition).
Nachteilig hieran ist vor allem eine sehr hoher und kostenintensiver Aufwand zum Umrüsten einer PICVD-Beschichtungsanlage, welche in ihrer Grundauslastung mit silizium- und titanhaltigen Precursorgasen wie Hexamethyldisiloxan und Titanchlorid betrieben wird.

Auch die DE 20 23 772 beschreibt als Substratmaterial für ein Entladungsgefäß ein auf der Innenseite mit einer Schutzschicht aus Aluminiumoxid beschichtetes Quarzglas, alternativ zur Verwendung von polykristallinem Aluminiumoxid als Entladungsgefäßmaterial.

Aus der DE 25 24 410 ist ein Entladungsgefäß aus glasartigem Siliziumdioxid bekannt, welches an seiner dem Entladungsraum abgewandten Außenseite eine Zone aufweist, in welches Aluminiumoxid eindiffundiert wurde. Diese Zone soll als Na-Diffusionsbarriere dienen.

**Aufgabe der Erfindung** ist es, ein Lampengefäß, wie etwa ein Entladungsgefäß aus Quarzglas bereitzustellen, welches aufgrund einer zumindest verzögerten Diffusion von Gasbestandteilen der Entladungsgasfüllung eine verlängerte Lebensdauer der Lampe zur Folge hat.

Diese Aufgabe wird erfindungsgemäß gelöst durch die.im kennzeichnenden Teil des Anspruchs 1 angegebenen Merkmale. Bevorzugte Ausführungsformen und Weiterbildungen der Erfindung sind den jeweiligen Unteransprüchen zu entnehmen.

Dementsprechend ist erfindungsgemäß ein Lampengefäß aus lichtdurchlässigem Material, vorzugsweise ein Entladungsgefäß für Gasentladungslampen mit einer. Diffusionsbarriereinnenschicht vorgesehen, bei welchem eine Diffusionsbarriereinnenschicht als Einzelschicht aufgebracht wird, welche aus Siliziumoxid besteht und mit einem CVD-Verfahren auf der Innenwandung des Lampengefäßes, vorzugsweise des Entladungsgefäßes aufgebracht wird.

Gemäß der Erfindung ist also vorgesehen, eine Diffusionsbarriereschicht aus SiO₂ an der Grenzfläche des Lampengefäßes, insbesondere eines Quarzglassubstrates eines Entladungsgefäßes zum Entladungsraum auszubilden. Außer für die Beschichtung von Gasentladungsgefäßen von Gasentladungslampen, vorzugsweise aus Quarzglas, kann die Erfindung auch allgemein für Lampengefäße aus transparentem Material eingesetzt werden.

Diffusionsbarrierebeschichtungen, wie sie erfindungsgemäß vorgeschlagen werden, können daher auch unter anderem für Lampengefäße von Glühlampen verwendet werden. Insbesondere auch bei Halogenlampen erweist sich eine Diffusionsbarriere als sinnvoll, um die Lebensdauer solcher Lampen zu erhöhen. So ist auch daran gedacht, beispielsweise auch die Lebensdauer von Halogenlampen für den Automobilbereich, wie H1, H4- oder H7-Lampen signifikant zu erhöhen. Neben Quarzglas-Gefäßen oder Quarzglas-enthaltenden Gefäßen können weiterhin auch Lampengefäße beschichtet werden, die ein Hartglas, insbesondere ein Aluminosilikatglas, Borosilikatglas, oder Aluminoborosilikatglas aufweisen oder aus einem solchen Glas bestehen. Weiterhin ist auch eine vorteilhafte Beschichtung von Lampengefäßen aus oder mit keramischem Material denkbar.

Es hat sich gezeigt, dass mikrokristallines oder submikrokristallines SiO₂ diffusionshemmend gegenüber Bestandteilen der Füllung eines Brenners oder einer Glühlampe ist. Hierbei ist sowohl eine Mischung aus mikrokristallinem SiO₂ und submikrokristallinem SiO₂ ebenso im Sinne der Erfindung, wie eine beispielsweise enge Kristallitgrößenverteilung.
Eine typische Ausgestaltung der Erfindung ist eine Kristallitgröße von kleiner 50 nm. Bevorzugte Kristallitgrößenverteilungen liegen im Bereich von kleiner 10 nm. Die Kristallitgrößen können hierbei sogar eine Größe von kleiner 2 nm haben. In diesem Fall liegen die Kristallite in der Größenordnung von nur wenigen Elementarzellen. Hierbei nimmt die Beweglichkeit von Füllungsbestandteilen in der Diffusionsbarriereschicht mit dem Grad der Ordnung der Einzelmoleküle des SiO₂ ab.

Die mikrokristalline Struktur und die eher dünne Schicht des mikrokristallinen SiO₂ gewährleisten dabei gleichzeitig den Beibehalt der Transparenz des Gefäßsubstrates, beispielsweise eines Entladungsgefäßsubstrates.

Ein besonders wirtschaftliches Verfahren zum Aufbringen einer solchen Diffusionsbarriereschicht aus mikrokristallinem und/oder submikrokristallinem SiO₂ ist das CVD-Verfahren. Bevorzugt werden hier reaktive Beschichtungsverfahren wie PICVD (Plasma-Impulse-Chemical-Vapour-Deposition),
- PECVD: (Plasma-Enhanced-Chemical-Vapour-Deposition),
- PACVD: (Plasma-Assisted-Chemical-Vapour-Deposition) und
- TCVD: (Thermal-Chemical-Vapour-Deposition).

Insbesondere das PICVD-Verfahren eignet sich zur Herstellung der erfindungsgemäßen Beschichtung. Hier kann das Schichtwachstum und die Kristallisation des SiO₂ gezielt über die Beschichtungsparameter gesteuert werden. Beschichtungsparameter zur Beeinflussung der Morphologie der aufwachsenden Schichten sind insbesondere die Temperatur im Reaktionsraum und auf der Beschichtungsoberfläche, die Mikrowellenleistungsdichte sowie der Partialdruck des Precursors (Precursoranteil im Gasvolumen) und damit die Konzentration des Si im Reaktionsraum.

Ein wesentlicher Faktor hierbei ist die Temperatur des Substrates vor dem Beginn des Beschichtungsvorgangs. Das Substrat muss zu Beginn des Beschichtens bereits heiß genug sein, damit sich die aufwachsende Schicht fest mit dem Untergrund verbinden kann. Ist dieses nicht der Fall, wachsen die ankommenden Si-Bestandteile nur aneinander fest und verbinden sich nicht fest genug mit dem Substrat, so dass sie nur einen staubähnlichen pulvrigen Belag auf dem Substrat ergeben.

Ist die Substrattemperatur von Anfang an höher, wachsen die ankommenden Si-Bestandteile zwar genügend fest auf dem Substrat an, das bedeutet aber noch nicht zwangsweise, dass die entstehende Schicht auch optisch transparent sein muss. Versuche haben vielmehr gezeigt, dass hierfür eine gewisse Mindesttemperatur des Substrates notwendig ist, die wiederum von der Art und Geometrie des Substrates abhängig ist. Ab einem bestimmten Temperaturbereich wachsen die Schichten optisch glasklar auf, während sie bei niedrigeren Anfangstemperaturen milchig-trüb erscheinen.

Ursache für das milchige Erscheinungsbild bei niedrigen Beschichtungstemperaturen ist ein Schichtwachstum in Form von ausgeprägtem Säulenwachstum. Die Grenzen zwischen den bevorzugt säulenartig aufwachsenden Kristalliten sind dabei optisch wirksam und verursachen eine starke Streuung des durchgehenden Lichtes, welches zu dem milchig-trüben Erscheinungsbild führt. Dieses Säulenwachstum ist bei hohen Substrattemperaturen zumindest weniger stark ausgeprägt oder wird sogar gänzlich unterdrückt, so dass bei hohen Temperaturen diese Streuzentren nicht mehr auftreten und somit das trübe Erscheinungsbild unterdrückt werden kann.

Ebenso wichtig wie eine genügend hohe Substrattemperatur zu Beginn des Beschichtungsvorgangs ist das Einhalten dieser Temperatur während des Beschichtungsvorgangs. Hierbei muss insbesondere darauf geachtet werden, dass die anfangs erreichte Substrattemperatur während des lang anhaltenden Beschichtungsvorganges durch richtige Wahl der Prozessparameter auch beibehalten werden kann, damit sich die Wachstumsbedingungen der Schichten während des Beschichtungsprozesses nicht ändern.
Die wesentlichste Einflussgröße beim PICVD-Verfahren zur Einstellung der Temperatur ist die Mikrowellenleistungsdichte im Reaktionsraum. Sie hängt wiederum wesentlich von der Größe und Form des Reaktionsraumes sowie von der Art der Ankopplung der Mikrowellenleistung ab.

Die benötigte Mikrowellenleistung kann durch geeignete Wahl der Pulshöhe und dem Verhältnis von Pulsdauer zu Pulspause eingestellt werden Durch entsprechend gewählte Mikrowellenparameter können somit beim Beschichten optisch glasklare Beschichtungen auf Reflektoren erreicht werden.

Weiterhin ist es wichtig, den Gasfluss im Verhältnis zur Mikrowellenleistungsdichte so einzustellen, dass das eingeleitete Precursorgas vollständig abreagiert, da ansonsten auch milchig-trübe Schichten entstehen können.

Um eine hohe Diffusionssperrwirkung der Schicht beispielsweise gegenüber Natrium-Ionen zu erreichen ist es notwendig, die Beschichtung bei besonders hohen Temperaturen aufzubringen, da die Schichten umso dichter und damit umso weniger durchlässig für diffundierende Natrium-Ionen sind, je höher die Temperaturen beim Aufwachsen der Schichten sind. Auch hierbei ist es wichtig, die bei niedrigeren Temperaturen ansonsten auftretenden Säulenstrukturen zu unterbinden, da diese Morphologie neben den optisch unerwünschten Streuzentren, die zu einem milchig-trüben Erscheinungsbild führen, auch in Hinsicht auf die Diffusion von Natrium-Ionen sehr ungünstig sind.
Die Diffusion von Ionen in einem Kristallgefüge findet generell bevorzugt entlang der Ränder der Kristalle statt (sog. Korngrenzendiffusion), was bei gewachsenen Säulen, deren Vorzugsrichtung gerade in Richtung durch die Schicht hindurch orientiert ist, für die beabsichtige Funktion einer Diffusionssperrwirkung besonders ungünstig ist.

Gegenstand der erfindungsgemäßen Barriereschicht ist deshalb eine wirkungsvolle Diffusionssperrschicht gegen Ionendiffusion die dadurch gekennzeichnet ist, dass die Kristallite mikrokristallin und/oder submikrokristallin sind.

Ein Vorteil der erfindungsgemäßen Diffusionsbarriereschicht aus mikrokristallinem und/oder submikrokristallinem SiO₂ auf Quarzglas ist weiterhin eine sehr hohe Affinität der aufgetragenen Atome zum Substratmaterial und damit eine ausgezeichnete Haftung der Schicht auf dem Substrat auch bei sehr hohen Temperaturen. Ein besonderer Vorteil ist es dabei, dass die Diffusionsbarriereschicht aus nahezu demselben Material wie das Substrat hergestellt wird. Da der thermische Ausdehnungkoeffizient beider Materialien damit identisch ist, ist keine oder eine nur sehr geringe Rissbildung bei hohen Temperaturen zu erwarten.

Typische Schichtstärken für eine Beschichtung aus mikrokristallinem und/oder submikrokristallinem SiO₂ betragen 10 bis 1000 nm, vorzugsweise 50 bis 500 nm. Ober die gewählte Schichtstärke kann die maximale Kristallitgröße beeinflusst werden.

Weiter kann die mikrokristalline und/oder submikrokristalline SiO₂ Diffusionsbarriereschicht nicht durch eine Beschichtung der Innenoberfläche des Quarzglassubstrates aufgebracht, sondern in der Grenzflächenzone des Quarzglassubstrates des Lampengefäßes, wie etwa eines Entladungsgefäßes zum Gefäßinnenaum, beziehungsweise zum Entladungsraum einer Gasentladungslampe gebildet werden. Dies erfolgt mittels einer thermischen Behandlung der Gefäßinnenoberfläche, beispielsweise der Entladungsgefäßinnenoberfläche von Gasentladungslampen.

Bei einer bevorzugten Ausführungsform des Verfahrens ist diese thermische Behandlung eine Wärmeeinbringung durch eine Plasmaentladung. Ein bevorzugtes Verfahren hierzu ist das CVD-Verfahren, wie
- PICVD: (**P**lasma-**I**mpulse-**C**hemical-**V**apour-**D**eposition),
- PECVD: (**P**lasma-**E**nhanced-**C**hemical-**V**apour-**D**eposition),
- PACVD: (**P**lasma-**A**ssisted-**C**hemical-**V**apour-**D**eposition) und
- TCVD: (**T**hermal-**C**hemical-**V**apour-**D**eposition).

Bei Verwendung des PICVD-Verfahrens kann diese Wärmeeinbringung in die Innenoberflächenzone des Quarzglassubstrates gezielt gesteuert werden. Auch hier wird eine mikrokristalline und/oder submikrokristalline Kristallstruktur im SiO₂ der Innenoberflächenzone erzeugt. Es wurde auch hier eine diffusionshemmende Wirkung gegenüber Bestandteilen der Brennerfüllung festgestellt.

Beim PICVD-Verfahren bietet es sich besonders an, die Wärmebehandlung der Oberfläche durch eine Plasmabehandlung mittels eines reaktiven Gases, bevorzugt eines reaktiven Ätzgases wie beispielsweise Sauerstoff und/oder Schwefelhexafluorid durchzuführen, wobei die Anregung des Plasmas und damit der Wirkungsgrad des Ätzgases durch die Wahl der Mikrowellenprozessparameter gezielt eingestellt werden kann. Hierbei sind wiederum die entscheidenden Parameter die Mikrowellenleistungsdichte, die über die Pulshöhe sowie über das Verhältnis Pulsdauer zu Pulspause eingestellt werden kann. Durch den Ätzvorgang des sehr reaktiven Gases bei hohen Temperaturen kann die Quarzglasschicht in einer dünnen Zone zumindest teilweise zum Kristallisieren gebracht werden, welches eine dünne mikrokristalline und/oder submikrokristalline Schicht erzeugt, welche eine erhöhte Sperrwirkung gegenüber Diffusion von Gasatomen aus dem Gasvolumen aufweist.

Möglich ist auch eine Kombination aus beiden verschieden hergestellten Diffusionsbarriereschichten, wie sie oben jeweils beschrieben wurden. Zunächst wird eine mikrokristalline und/oder submikrokristalline Kristallstruktur im SiO₂ der Innenoberflächenzone des Quarzglassubstrates, vorzugsweise mittels Wärmeeinbringung durch eine Plasmaentladung, beispielsweise mit Hilfe eines Ätzgases, erzeugt. Auf diese Schicht wird anschließend eine weitere mikrokristalline und/oder submikrokristalline SiO₂ -Schicht mittels eines CVD-Verfahrens aufgebracht.

Vorteil dieser Kombination aus beiden verschieden hergestellten Diffusionsbarriereschichten ist es, dass die zuerst hergestellte mikro- oder submikrokristalline Kristallstruktur eine geeignete Unterlage für die durch einen CVD-Prozess aufgebrachte zweite Diffusionsbarriereschicht darstellt. Insbesondere werden sich die beiden auf unterschiedliche Weise hergestellten mikro- oder submikrokristallinen Schichten neben gegebenenfalls Unterschieden in der chemischen Zusammensetzung insbesondere in ihrer durchschnittlichen Kristallitgröße, ihrer Kristallitgrößenverteilung und ihrer Vorzugsorientierung der Kristallite (Morphologie) unterscheiden.
(Gegebenenfalls Unterschiede in der chemischen Zusammensetzung bezieht sich auf Rückstände aus dem Precursorgas der SiO₂-Beschichtung in der auf das Quarzglassubstrat aufgetragenen
Diffusionsbarriereinnenschicht. Solche Rückstände unterstützen vermutlich die diffusionshemmende Wirkung der erfindungsgemäßen Innenbeschichtung. Als Precursorgas wird eine organische Siliziumverbindung, vorzugsweise Hexamethyldisiloxan verwendet.)

So kann es beispielsweise sein, dass durch die Wärmeeinbringung mittels einer Plasmaentladung, beispielweise mit Hilfe eines Ätzgases, in einer dünnen Zone eine sehr feinkörnige Kristallitgrößenverteilung im Bereich < 10 nm entsteht, während beim Aufwachsen einer Beschichtung mittels eines CVD-Prozesses, beispielsweise eines PICVD-Prozesses, die durchschnittliche Kristallitgrößenverteilung sehr viel größer ist, beispielsweise 10 - 500 nm, da die entstehenden Kristallitgrößen sehr oft in der Größenordnung der aufgebrachten Schichtdicke liegen.

Es ist weiterhin beobachtet worden, dass beim Aufbringen einer Si02-Schicht auf Glas oder Quarzglas mit Hilfe eines CVD-Verfahrens, insbesondere mit einem PICVD-Verfahren, die entstehenden Kristallite bevorzugt säulenförmig aufwachsen. Die Ausprägung dieser bevorzugten Wachstumsform kann verringert werden, indem die Oberfläche beim Beschichtungsvorgang sehr hohe Temperatur hat und/oder sie vorher geeignet behandelt wurde.

Diese geeignete Behandlung kann beispielsweise eine oberflächliche Kristallisation des Quarzglases sein, so dass beim Aufwachsen mittels CVD-Beschichtungsprozesses keine freie Grenzfläche zwischen amorphem Quarzglas und aufwachsender Si02-Schicht mehr vorhanden ist. Durch die Wechselwirkung zwischen der kristallinen Oberfläche.und dem aus dem CVD-Prozess kondensierenden Gas können die Bestandteile nicht mehr in der ansonsten bevorzugten Säulenstruktur aufwachsen. Die Ursache hierfür kann darin liegen, das in diesem Fall die aufwachsenden Kristalle gezwungen sind, sich nach der Orientierung der bereits vorhanden kleinen Kristallite zu orientieren, und ihre ansonsten bevorzugte Wachstumsform einer säulenförmig strukturierten Schicht nicht mehr annehmen können.

Daher kann es vorteilhaft sein, zuerst eine submikrokristalline Schicht durch eine geeignete thermische Behandlung, beispielsweise mit Hilfe eines Ätzgases, auf dem Quarzglaskolben zu erzeugen, und erst darauf durch einen CVD-Beschichtungsvorgang eine mikrokristalline Beschichtung aufzubringen.

Besonders wirtschaftlich gestaltet sich dieses Kombi-Verfahren in ein und derselben Anlage, wofür sich besonders gut eine Anlage zum Beschichten mittels PICVD-Verfahren eignet. Für eine PICVD-Beschichtungsanlage, welche ausgelegt ist für eine Beschichtung von Substraten u.a. mittels-siliziumhaltigen Precursorgasen wie Hexamethyldisiloxan, ist es ohne große Umbauten leicht möglich, eine weitere Gasart für einen Ätzvorgang, beispielweise Sauerstoff oder Schwefelhexafluorid, einzuleiten, wie es beispielhaft für eine Wärmebehandlung der Quarzglasoberfläche durch eine Plasmabehandlung mittels eines reaktiven Ätzgases für eine erfindungsgemäße Herstellung einer Diffusionsbarriereschicht notwendig ist. Durch das erfindungsgemäße Verfahren kann ein teures und aufwendiges Umrüsten der Anlage vermieden werden. Hexamethyldisiloxan eignet sich in sehr guter Weise als Precursorgas für die erfindungsgemäße Beschichtung einer Brennerinnenoberfläche mit einer Diffusionsbarriereschicht.

Die erfindungsgemäß hergestellten Entladungsgefäße finden Anwendung als Metallhalogenid-Lampen. Insbesondere sind hier zu nennen:
- Metallhalogenidhochdrucklampe mit und ohne Quecksilberzusatz für die Kfz-Scheinwerfer, sog. "Xenonlicht" mit einem typischen Xenon-Kaltfülldruck zwischen 5-15 bar.
- Metallhalogenidhochdrucklampen für die Allgemeinbeleuchtung.
- Metallhalogenidhochdrucklampen für die Projektionszwecke.
- Quecksilberhöchstdrucklampen für Projektionsanwendungen, die einen Halogenkreisprozess verwenden.

Die Erfindung wird anhand der Zeichnung beispielhaft näher erläutert. Hierbei zeigt:
- Fig.1: eine Metallhalogenidlampe (D-Lampe), wie sie beispielsweise für Kraftfahrzeuge verwendet wird.
- Fig.2: eine Diffusionsbarriereschicht als Beschichtung auf der Innenoberfläche eines Quarzkolbensubstrates eines Entladungsgefäßes
- Fig.3: eine Diffusionsbarriereschicht als Zone der Innenoberfläche eines Quarzkolbensubstrates eines Entladungsgefäßes
- Fig.4: eine Diffusionsbarriereschicht als Beschichtung auf der Innenoberfläche eines Quarzkolbensubstrates eines Entladungsgefäßes in Kombination mit einer Diffusionsbarriereschicht als Zone der Innenoberfläche eines Quarzkolbensubstrates

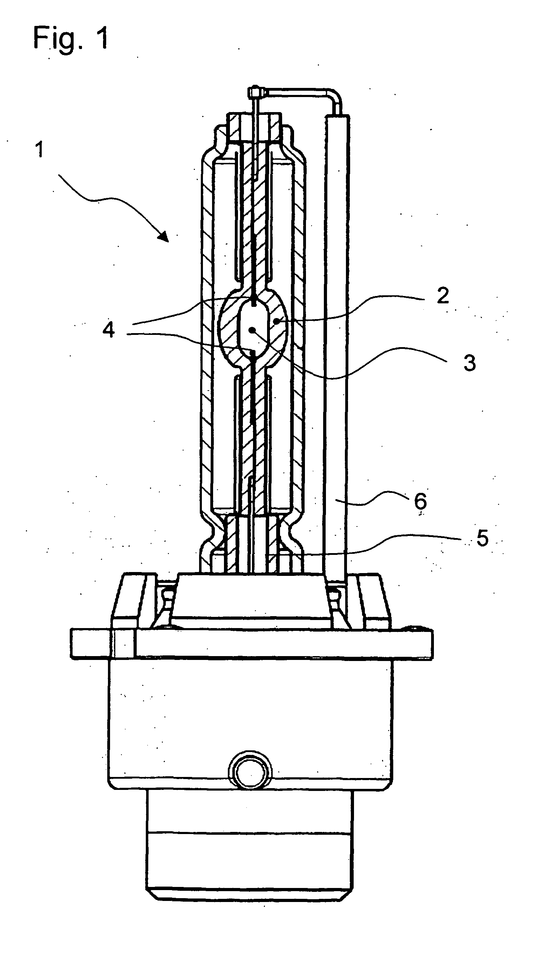

Figur 1 zeigt den Ausschnitt einer Xenon - Kurzbogenlampe 1. Der Entladungsraum 3 ist gefüllt mit Xenon als Entladungsgas, gegebenenfalls noch mit weiteren Gasbestandteilen wie Natriumiodid, Scandiumiodid und Zinkiodid. Zum Betrieb der Entladung sind in dem Entladungsgefäß aus Quarzglas 2 Wolframelektroden 4 über Dichtungsfolien gasdicht eingebracht. Ein Sockel mit Stromanschluss 5 sowie ein Schaft 6 mit Stromzuführung bilden Bestandteile der Stromzuführung. Eine beispielhafte Ausführung einer solchen D-Lampe mit einer Gasfüllung jeweils als quecksilberhaltige und quecksilberfreie Ausführung und einer erfindungsgemäßen Innenbeschichtung des Entladungsgefäßes aus Quarzglas 2 gibt nachfolgende Tabelle.

| | **D2** **(Quecksilberhaltig)** | **D4** **(Quecksilberfrei)** | **Bemerkung** |
|---|---|---|---|
| **Brennspannung (V)** | 85 | 42 | Nennwert |
| **Leistung (W)** | 35 | 35 | Nennwert |
| **Elektrodenabstand (mm)** | 4,2 | 4,2 | Nennwert |
| **Kaltfülldruck** Xenon **(bar)** | 8 | 10 bis 15 | typische Werte |
| **Hg-Menge (mg)** | 0,5 | 0 | typische Werte |
| **Metallhalogenid (mg)** | 0,3 | 0,4 | typische Werte |
| davon NaI | 70% | 55% | typische Werte |
| davon ScI3 | 30% | 25% | typische Werte |
| davon ZnI | 0% | 15% | typische Werte |
| andere | 0% | 5% | typische Werte |

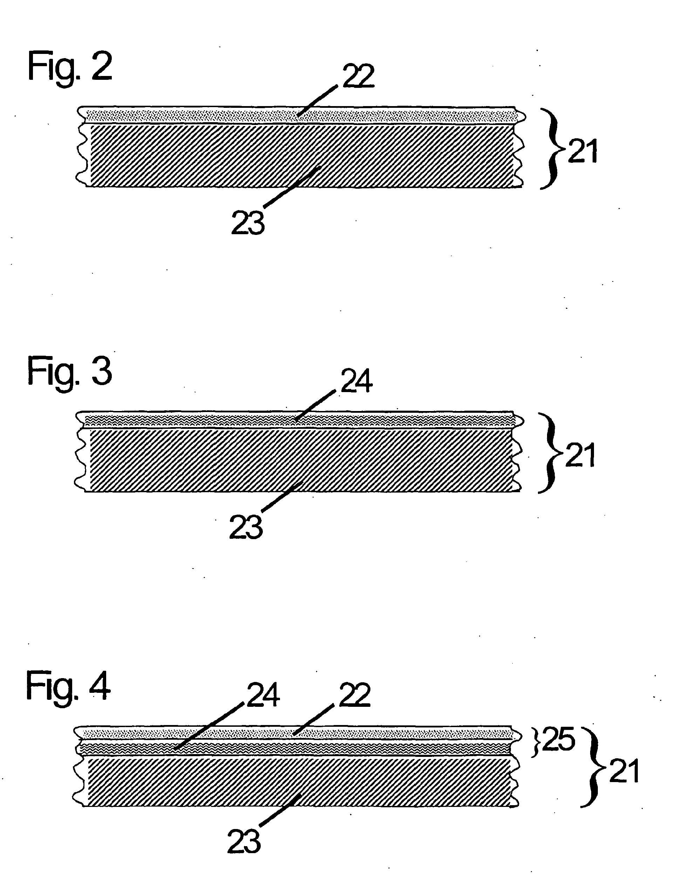

Die Figuren 2 bis 4 zeigen jeweils einen vergrößerten Ausschnitt der Wandung des Lampengefäßes, wie etwa des Entladungsgefäßes aus Quarzglas 2. Hierbei weisen jeweils die Diffusionsschichten 22 bzw. 24 in Richtung Entladungsraum.

Figur 2 zeigt eine Diffusionsbarriereschicht 22 als Beschichtung auf der Innenoberfläche des Quarzglassubstrates 21 des Entladungsgefäßes. Die Beschichtung wurde als mikrokristalline und/oder submikrokristalline SiO₂ -Schicht mittels PICVD-Verfahren auf das glasige SiO₂ 23 des Quarzglassubstrates 21 aufgebracht

Figur 3 zeigt eine Diffusionsbarriereschicht 24 als Zone der Innenoberfläche des Quarzkolbensubstrates 21 des Entladungsgefäßes. Diese ebenfalls mikrokristalline und/oder submikrokristalline SiO₂ -Schicht wurde durch Kristallisation der Innenoberflächenzone des Quarzglassubstrates 21 des Entladungsgefäßes mittels Wärmeeinbringung durch Plasmaentladungen erzeugt. Unmittelbar angrenzend und verzahnt mit dieser Diffusionsbarriereschicht 24 ist die hintere glasige Zone 23 des Quarzglassubstrates 21.

Figur 4 zeigt eine Kombination der beiden Diffusionsbarriereschichten entsprechend Figur 2 und 3. Zunächst wurde eine Diffusionsbarriereschicht 24 als Zone der Innenoberfläche des Quarzkolbensubstrates 21 durch Kristallisation der Innenoberflächenzone des Quarzglassubstrates 21 mittels Wärmeeinbringung durch Plasmaentladungen erzeugt. Im Anschluss daran wurde eine weitere Diffusionsbarriereschicht 22 als Beschichtung auf die als Diffusionsbarriereschicht 24 ausgebildete Innenoberfläche des Quarzkolbensubstrates 21 mittels PICVD-Verfahren aufgebracht. Aufgrund der Wechselwirkung der Atome haben beide mikrokristallinen und/oder submikrokristallinen SiO₂ -Schichten eine große Haftung zueinander. Die vorstehend beschriebenen Ausführungsbeispiele können entsprechend auch für andere Lampentypen und andere Substratmaterialien verwendet werden. Gedacht ist hier insbesondere auch an Lampengefäße von Halogenlampen, die außer aus Quarzglas alternativ oder zusätzlich auch andere Materialien, wie Hartgläser oder Keramik gefertigt sein können.

Es ist dem Fachmann offensichtlich, daß die Erfindung nicht auf die vorstehend beschriebenen Ausführungsbeispiele beschränkt ist, sondern vielmehr in vielfältiger Weise abgewandelt werden kann. Insbesondere können die Ausführungsbeispiele auch miteinander kombiniert werden.

## Patentansprüche

1. Lampengefäß, insbesondere Entladungsgefäß für Entladungslampen aus einem Quarzglas mit einer Diffusionsbarriereinnenschicht (22, 24), welche eine Einzelschicht ist und aus mikrokristallinem Siliziumoxid besteht, **dadurch gekennzeichnet, dass** die Kristallitgröße des Siliziumdioxids der Diffusionsbarriereinnenschicht kleiner 50 nm beträgt.

2. Lampengefäß, insbesondere Entladungsgefäß nach Anspruch 12, **dadurch gekennzeichnet, dass** die Kristallitgröße des Siliziumdioxids der Diffusionsbarriereinnenschicht kleiner 10 nm beträgt.

3. Lampengefäß, insbesondere Entladungsgefäß nach einem der Ansprüche 1 oder 2, **dadurch gekennzeichnet, dass** die Schichtstärke der Diffusionsbarriereinnenschicht 10 bis 2000 nm, vorzugsweise 50 bis 500 nm beträgt.

4. Lampengefäß, insbesondere Entladungsgefäß nach einem der vorstehenden Ansprüche, **dadurch gekennzeichnet, dass** die Diffusionsbarriereinnenschicht (22) als Beschichtung auf der Innenoberfläche des Gefäßinnenraums, insbesondere des Entladungsgefäßes aufgebracht ist.

5. Lampengefäß, insbesondere Entladungsgefäß nach einem der vorhergehenden Ansprüche, **dadurch gekennzeichnet, dass** die Diffusionsbarriereinnenschicht eine Diffusionsbarriere gegen Natrium und/oder Scandium und/oder Zink bildet.

6. Lampengefäß einer Glühlampe, insbesondere einer Halogenlampe, gemäß einem der vorstehenden Ansprüche.

7. Lampengefäß, insbesondere Entladungsgefäß nach einem der vorhergehenden Ansprüche, **dadurch gekennzeichnet, dass** das Lampengefäß, insbesondere das Entladungsgefäß Natrium enthält.

8. Lampengefäß, insbesondere Entladungsgefäß nach einem der vorhergehenden Ansprüche, **dadurch gekennzeichnet, dass** das Lampengefäß, insbesondere Entladungsgefäß Iod oder Brom enthält.

9. Metallhalogenid-Lampe umfassend ein Lampengefäß, insbesondere ein Entladungsgefäß nach einem der vorhergehenden Ansprüche.

10. Hochdrucklampe oder Höchstdrucklampe umfassend ein Entladungsgefäß nach einem der vorhergehenden Ansprüche.

11. Beleuchtungseinrichtung im Automobilbereich umfassend ein Lampengefäß, insbesondere ein Entladungsgefäß, nach einem der vorhergehenden Ansprüche.

## Claims

1. Lamp bulb, in particular discharge bulb for discharge lamps made of a quartz glass having a diffusion barrier internal layer (22, 24) which is a single layer and consists of microcrystalline silicon oxide, **characterised in that** the crystallite size of the silicon dioxide of the diffusion barrier internal layer is less than 50 nm.

2. Lamp bulb, in particular discharge bulb as claimed in claim 12 *[sic],* **characterised in that** the crystallite size of the silicon dioxide of the diffusion barrier internal layer is less than 10 nm.

3. Lamp bulb, in particular discharge bulb as claimed in any one of claims 1 or 2, **characterised in that** the layer thickness of the diffusion barrier internal layer is 10 to 2000 nm, preferably 50 to 500 nm.

4. Lamp bulb, in particular discharge bulb as claimed in any one of the preceding claims, **characterised in that** the diffusion barrier internal layer (22) is applied as a coating to the inner surface of the internal space of the bulb, in particular of the discharge bulb.

5. Lamp bulb, in particular discharge bulb as claimed in any one of the preceding claims, **characterised in that** the diffusion barrier internal layer forms a diffusion barrier against sodium and/or scandium and/or zinc.

6. Lamp bulb of an incandescent lamp, in particular of a halogen lamp, as claimed in any one of the preceding claims.

7. Lamp bulb, in particular discharge bulb as claimed in any one of the preceding claims, **characterised in that** the lamp bulb, in particular the discharge bulb contains sodium.

8. Lamp bulb, in particular discharge bulb as claimed in any one of the preceding claims, **characterised in that** the lamp bulb, in particular the discharge bulb contains iodine or bromine.

9. Metal halide lamp comprising a lamp bulb, in particular a discharge bulb as claimed in any one of the preceding claims.

10. High pressure lamp or extreme high pressure lamp having a discharge bulb as claimed in any one of the preceding claims.

11. Lighting device for the automobile sector having a lamp bulb, in particular a discharge bulb, as claimed in any one of the preceding claims.

## Revendications

1. Récipient de lampe, en particulier récipient de décharge pour des lampes à décharge à base d'un verre de quartz avec une couche intérieure de barrière de diffusion (22, 24), qui est une couche individuelle et est à base d'oxyde de silicium monocristallin, **caractérisé en ce que** la grandeur de cristallite du dioxyde de silicium de la couche intérieure de barrière de diffusion est inférieure à 50 nm.

2. Récipient de lampe, en particulier récipient de décharge selon la revendication 12, **caractérisé en ce que** en ce que la grandeur de cristallite du dioxyde de silicium de la couche intérieure de barrière de diffusion est inférieure à 10 nm.

3. Récipient de lampe, en particulier récipient de décharge selon l'une quelconque des revendications 1 ou 2, **caractérisé en ce que** l'épaisseur de couche de la couche intérieure de barrière de diffusion est de 10 à 2000 nm, de préférence 50 à 500 nm.

4. Récipient de lampe, en particulier récipient de décharge selon l'une quelconque des revendications précédentes, **caractérisé en ce que** la couche intérieure de barrière de diffusion (22) est appliquée sous forme de revêtement sur la surface intérieure de l'espace intérieur du récipient, en particulier du récipient de décharge.

5. Récipient de lampe, en particulier récipient de décharge selon l'une quelconque des revendications précédentes, **caractérisé en ce que** la couche intérieure de barrière de diffusion forme une barrière de diffusion contre le sodium et/ou le scandium et/ou le zinc.

6. Récipient de lampe d'une lampe à incandescence, en particulier d'une lampe à halogène, selon l'une quelconque des revendications précédentes.

7. Récipient de lampe, en particulier récipient de décharge selon l'une quelconque des revendications précédentes, **caractérisé en ce que** le récipient de lampe, en particulier le récipient de décharge, contient du sodium.

8. Récipient de lampe, en particulier récipient de décharge selon l'une quelconque des revendications précédentes, **caractérisé en ce que** le récipient de lampe, en particulier le récipient de décharge, contient de l'iode ou du brome.

9. Lampe à halogénure de métal, comprenant un récipient de lampe, en particulier un récipient de décharge selon l'une quelconque des revendications précédentes.

10. Lampe à haute pression ou lampe à pression maximale comprenant un récipient de décharge selon l'une quelconque des revendications précédentes.

11. Dispositif d'éclairage dans le secteur automobile comprenant un récipient de lampe, en particulier un récipient de décharge, selon l'une quelconque des revendications précédentes.
